# EUROPÄISCHE PATENTANMELDUNG

(11) **EP 2 746 044 A1**
(43) Veröffentlichungstag der Anmeldung: **25.06.2014**
(21) Anmeldenummer: 12198666.5
(22) Anmeldetag: 20.12.2012
(51) Int. Cl.: B32B 17/10, H01L 31/048

(54) **Photovoltaikmodule mit effizienzsteigernden Klebefolien**

(71) Anmelder: Kuraray Europe GmbH, 65795 Hattersheim (DE)
(72) Erfinder: Keller, Uwe, Dr., 53177 Bonn (DE); Beekhuizen, Jan, Dr., 53844 Troisdorf (DE); Karpinski, Andreas, 51519 Odenthal (DE); Steuer, Martin, Dr., 65835 Liederbach (DE)
(74) Vertreter: Kisters, Michael Marcus

(57) **Zusammenfassung**

Die Erfindung betrifft Photovoltaikmodule, umfassend ein Laminat aus
a) einer transparenten Frontabdeckung
b) mindestens einer Klebefolie mit hoher Strahlungstransmission, enthaltend weichmacherhaltiges Polyvinylacetal
c) einer oder mehreren photosensitiven Halbleiterschichten
d) mindestens einer reflektierenden Klebefolie, enthaltend weichmacherhaltiges Polyvinylacetal
e) einer rückwärtigen Abdeckung

wobei die Klebefolie mit hoher Strahlungstransmission b) eine UV-Transmission von mehr als 35 % aufweist, bestimmt zwischen zwei Scheiben Weißglas von 2 mm Dicke nach EN410.
Bevorzugt ist die Klebefolie mit hoher Strahlungstransmission b) im Wesentlichen frei von UV-Absorber.

## Beschreibung

### Technisches Gebiet

Die Erfindung betrifft die Herstellung von Photovoltaikmodulen unter Verwendung von Klebefolien zur Steigerung der Quantenausbeute durch Verwendung einer Kombination aus Sonnenlicht-Reflektierenden Klebefolien und Klebefolien mit hoher Strahlungstransmission.

Photovoltaikmodule bestehen häufig aus einer photosensitiven Schicht, die zwischen einer Glasplatte und einer hinteren Abdeckung angeordnet ist. Insbesondere wenn die hintere Abdeckung ebenfalls aus Glas besteht, werden diese Komponenten über ein oder mehrere Zwischenschichtfolien aus weichmacherhaltigem Polyvinylbutyral (PVB) miteinander verklebt.

Es ist zudem bekannt, dass ein Teil des Sonnenlichts die photosensitiven Schichten durchdringt, ohne diese anzuregen. Zur Verbesserung der Quantenausbeute können insbesondere die hinter den photosensitiven Schichten angeordneten Klebefolien reflektierende Materialien wie Titandioxid, Zirkondioxid oder Metallpigmente enthalten. So ist aus DE 4337694, WO 2009/071703, US 2007/0235077 oder US 5,059,254 die Verwendung von Titandioxid als reflektierendes Pigment in einer hinter der photosensitiven Schicht befindlichen PVB-Folie bekannt.

Weiterhin ist bekannt, dass marktübliche PVB-Folie wird mit UV-Absorbern, insbesondere mit Abkömmlingen des Benzotriazols, als Additiv ausgerüstet wird. Hierdurch wird die UV-Strahlung ganz oder teilweise absorbiert, was zwar das photosensitive Schichtsystem des Photovoltaikmoduls vor Strahlenschäden schützt, aber den für die photosensitiven Schichten verwertbaren Strahlungsanteil herabsetzt. So enthalten kommerziell als Einkapselungsmaterialien verwendete PVB-Folien UV-Absorber des Benzotriazol-Typs (wie z. B. Tinuvin 328) und weisen im Verbund zwischen 2 x 2 mm Weißglas nach EN 410 gemessen eine UV-Transmission von weniger als 0,5 % im Wellenlängenbereich von 280 - 380 nm auf. In ähnlicher Weise enthalten Einkapselungsfolien auf Basis EVA zu dessen Schutz UV-Absorber und weisen daher ähnlich geringe Transmissionswerte für UV-Strahlung auf. Strahlung unterhalb der Wellenlänge von 380 nm steht dadurch bei Verwendung der üblichen PVB-Folien bzw. EVA für die Erzeugung von Photostrom nicht zur Verfügung.

### Aufgabe

Aufgabe der vorliegenden Erfindung war es daher, Zwischenschichtfolien für Photovoltaikmodule zur Verfügung zu stellen, die eine verbesserte Ausnutzung des Sonnenlichts erlauben.

Es wurde gefunden, dass ein Solarmodul, bei dem eine reflektierende Klebefolie hinter und eine Klebefolie mit hoher Strahlungstransmission vor der photosensitiven Schicht angeordnet ist, eine verbesserte Effizienz aufweist.

### Darstellung der Erfindung

Gegenstand der vorliegenden Erfindung sind daher Photovoltaikmodule, umfassend ein Laminat aus
a) einer transparenten Frontabdeckung
b) mindestens einer Klebefolie mit hoher Strahlungstransmission, enthaltend weichmacherhaltiges Polyvinylacetal
c) einer oder mehreren photosensitiven Halbleiterschichten
d) mindestens einer reflektierenden Klebefolie, enthaltend weichmacherhaltiges Polyvinylacetal
e) einer rückwärtigen Abdeckung
**dadurch gekennzeichnet, dass** die Klebefolie mit hoher Strahlungstransmission b) eine UV-Transmission von mehr als 35 % aufweist, bestimmt zwischen zwei Scheiben Weißglas von 2 mm Dicke nach EN410.

### Klebefolie mit hoher Strahlungstransmission b)

Gemäß EN 410 wird die UV-Transmission der Klebefolie b) im Wellenlängenbereich von 280 - 380 nm bestimmt.

Bevorzugt werden photosensitive Halbleiterschichten eingesetzt, die in diesem Wellenlängenbereich Strahlung absorbieren und in elektrische Energie umwandeln können.

Besonders vorteilhaft ist die Verwendung der Klebefolien b) für speziell auf UV-Strahlung ansprechende Solarzellen bzw. diese enthaltende Module, welche ansonsten im sichtbaren Bereich des Spektrums transparent sind. Solche Systeme filtern den schädlichen UV-Anteil des Spektrums heraus und dienen zugleich zur Erzeugung von Photostrom.

Erfindungsgemäß verwendete Folien b) weisen bevorzugt eine UV-Transmission von mehr als 50 %, gemessen im Verbund zwischen zwei Scheiben Weißglas in Stärke 2 mm nach EN 410, besonders bevorzugt von mehr als 70 % auf.

Dies kann erreicht werden, wenn die Folien b) im Wesentlichen frei von UV-Absorbern sind, d.h. deren Konzentration liegt unter 0,01 Gew.%, bevorzugt unter 0,001 Gew.%, besonders bevorzugt bei 0 Gew.%, jeweils bezogen auf die Folienmischung.

Eine ausreichende UV-Stabilität der Folien b) kann durch Selektion des zur Herstellung des Polyvinylacetals herangezogenen Polyvinylalkohol (PVA) erreicht werden. Liegen bereits auf Stufe des PVA ungesättigte Einheiten in der Polymerkette als Fehlstellen vor, finden sich diese zwangsläufig auch im daraus erzeugten Polyvinylacetal wieder und verschlechtern dessen Lichtstabilität bzw. UV-Transmission. Auf Stufe des PVA können die ungesättigten Einheiten in Form von isolierten oder in Konjugation zueinander oder in Konjungation zu Carbonylbindungen stehenden Doppelbindungen vorliegen. Diese ungesättigten Einheiten im PVA lassen sich durch UV-Spektroskopie nachweisen.

Sehr hohe Anteile an Fehlstellen führen bei Messung des PVA als 4 Gew.%-iger Lösung in H₂O zu Extinktionen bei 280 nm von nahe 1. Zur Herstellung von erfindungsgemäß verwendetem Polyvinylacetal wird daher Polyvinylalkohol eingesetzt, welcher in einer 4 Gew.% wässrigen Lösung bei 280 nm Extinktionswerte von weniger als 0.5, von weniger als 0.3, insbesondere 0.2 und bevorzugt 0.1 aufweist.

In der Praxis kann ein Polyvinylacetal als Basisrohstoff für die Klebefolie b) zwar bereits unter optimierten Bedingungen produziert werden, das Vorliegen von einigen Fehlstellen entlang oder am Ende der Polymerketten kann jedoch nicht gänzlich verhindert werden. Deshalb kann es sinnvoll sein, dem Polyvinylacetal bzw. der Folienmischung bei Verzicht auf UV-Absorber ausgewählte Lichtstabilisatoren hinzuzufügen.

Alternativ oder zusätzlich zum weitgehenden Verzicht auf UV-Absorber und/oder zur Verwendung von besonders Fehlstellenarmen PVB können die erfindungsgemäß verwendeten Klebefolien b) mit einem oder mehreren nicht-aromatischen Lichtstabilisatoren, insbesondere mit sterisch gehinderten (nicht-aromatischen) Aminen vom Typ HALS und/oder sterisch gehinderten (nicht-aromatischen) Aminoethern (NOR-HALS) ausgerüstet werden. Durch die Beschränkung auf nicht-aromatische Produkte wird sichergestellt, dass sich die Transmission der Folie im UV-Bereich von 280 - 380 nm nicht unnötig verschlechtert. Erfindungsgemäß verwendete Folien b) enthalten bevorzugt 0,005 - 1 Gew.-%, besonders bevorzugt 0,01 - 0,5 Gew.-%, insbesondere 0,05 - 0,3 Gew.-% und am meisten bevorzugt 0,10 - 0,25 Gew.-% an nicht-aromatischen Lichtstabilisatoren, wie sterisch gehinderten Aminen vom HALS oder NOR-HALS Typ.

Weichmacherhaltige Folien b) enthalten bevorzugt im Wesentlichen keine aromatischen UV-Absorber und 0,005 bis 1 Gew.% sterisch gehinderte Amine (HALS) und/oder sterisch gehinderte Aminoether (NOR-HALS).

Besonders geeignete Amine sind sterisch gehinderte Amine der allgemeinen Formeln I, II und oder III 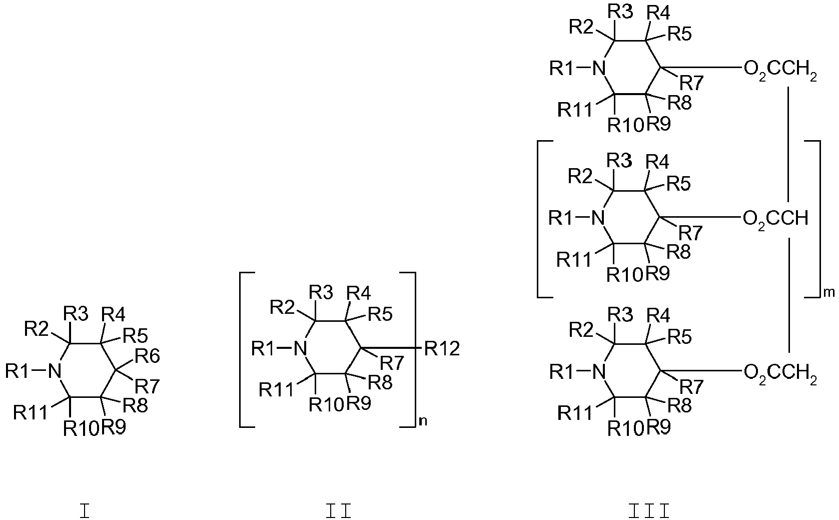 mit R1, R2, R3, R4, R5, R6, R7, R8, R9, R10, R11 = nicht-aromatische Substituenten wie H, C1 - C20 Alkyl, Hydroxyalkyl, Alkoxyalkyl, Acyloxyalkyl, jeweils unsubstituiert oder durch Aldehyd-, Keto- oder Epoxidgruppen substituiert
R12 = glatte Verbindung, C1 - C20 Alkyl, Hydroxyalkyl, Alkoxyalkyl, Acyloxyalkyl, jeweils unsubstituiert oder durch Aldehyd-, Keto- oder Epoxidgruppen substituiert
n = 2 - 4
m = 1 - 10.

Verbindungen dieser Art sind kommerziell erhältlich, beispielsweise durch die Produkte Tinuvin 123 (NOR-HALS), Tinuvin 144, Tinuvin 622, Tinuvin 770 der Fa. Ciba Specialities. Besonders gut geeignet sind beispielsweise ADK Stab LA-57, LA-52 oder LA-62 der Fa. Asai Denka Co. oder UVINUL 4050 H der BASF AG. Weniger geeignet sind Sanduvor PR-31 oder Chimasorb 119 aufgrund ihrer ungesättigten Molekülbestandteile (Sanduvor PR-31: Anisolrest; Chimasorb 119: Triazinring), welche zu hoher Absorption im UV-Bereich führen.

### Reflektierende Klebefolie d)

Durch die diffus reflektierend ausgerüstete Klebefolie d) wird ein Teil des Lichts, das die photosensitive Halbleiterschicht durchdringt, wieder auf diese zurückreflektiert, sodass sich die Effizienz des Photovoltaikmoduls erhöht.

Die reflektierende Klebefolie d) enthält bevorzugt Titandioxidpigment, insbesondere ein Titandioxidpigment mit einem TiO₂-Gehalt von 50 bis 94 Gew.%.

Das verwendete TiO₂ liegt insbesondere in der Rutil-Modifikation vor.

Erfindungsgemäß verwendete Folien weisen einen Erhalt der Reflektion bei 1100 nm vor und nach 1000h UV-Bestrahlung nach dem im folgenden beschriebenen Testverfahren von mindestens 85 %, bevorzugt von mindestens 90 % und insbesondere von mindestens 95 % auf.

Durch den Einsatz von ausgewählten Titandioxidpigmenten kann eine Verfärbung der Folie unterdrückt werden und die Effizienzsteigerung bleibt über die Lebensdauer des Moduls erhalten.

Die reflektierenden Klebefolien d) enthalten daher bevorzugt Titandioxidpigment welches mit einer oder mehreren Verbindungen der Gruppe Zinkoxid, Siliziumoxid, Aluminiumoxid und Zirkoniumoxid beschichtet ist. Bevorzugt wird als Beschichtungsmaterial eine Mischung von Silizium- und Aluminiumoxid eingesetzt.

Die erfindungsgemäß verwendeten Titandioxidpigmente weisen bevorzugt eine mittlere Partikelgröße von 10-80 nm, besonders bevorzugt von 15-60 nm und insbesondere von 20-40 nm auf.

Der anorganische Anteil der verwendeten Titandioxidpigmente enthält daher maximal 94 Gew.% TiO₂. Bevorzugt enthalten die erfindungsgemäße verwendeten Pigmente maximal 93 Gew.%, besonders bevorzugt maximal 92 Gew.% TiO₂, insbesondere maximal 91 Gew.% TiO₂. Der TiO₂-Gehalt der Titandioxidpigmente sollten jedoch mehr als 50 % TiO₂, bevorzugt mehr als 70 % TiO₂, besonders bevorzugt mehr als 80 % TiO₂ und insbesondere mehr als 85 % betragen, da sonst die Reflektivität der Folie d) zu gering wird.

Weiterhin können die Titandioxidpigmente zur Erleichterung der gleichmäßigen Einarbeitung in die Folienmatrix optional mit organischen Verbindungen oberflächenbehandelt sein. Beispiele hierfür sind Organophosphate, Organosulfate, Polysiloxan oder Siliconverbindungen wie Polydimethylsiloxan (PDMS). Bevorzugt besteht die Oberflächenbehandlung aus einer Siliconverbindung wie PDMS. Weniger geeignet sind polyfunktionelle Alkohole (z.B. TMP), da diese die Blauverfärbung verstärken können.

Der neben dem TiO₂ zu 100 % fehlende Rest der Titandioxidpigmente besteht aus den genannten, anorganischen und/oder organischen Verbindungen.

Die erfindungsgemäß eingesetzte reflektierende Klebefolie d) ist bevorzugt eine einlagige Folie. Es kann aber vorteilhaft sein, dass die reflektierende Klebefolie aus mindestens einer reflektierenden d.h. pigmenthaltigen Schicht (Teilfolie) und mindestens einer nicht-reflektierenden d.h. pigmentfreien Schicht (Teilfolie)besteht. So können z.B. ein oder zwei außen liegende Teilschichten die Klebewirkung bewirken, während die dazwischen liegende, die reflektierenden Pigmente enthaltende Teilschicht für die Reflexion der Strahlung sorgt.

Folien mit mehreren Teilschichten können durch Zusammenlegen von vorgefertigten Teilschichten oder durch Coextrusion der Teilschichten in einem Arbeitsgang hergestellt werden.

Der Anteil der Titandioxidpigmente in der reflektierenden Klebefolie d) beträgt bevorzugt mindestens 5 Gew.%, besonders bevorzugt mindestens 8 Gew.%, oder mindestens 10 Gew.% und insbesondere mindestens 12 Gew.-% (bezogen auf die Folie). Als Obergrenze sollte jeweils 30 Gew.% eingehalten werden. Ist die Klebefolie d) aus pigmentfreien und pigmenthaltigen Teilschichten aufgebaut, so bezieht sich dieser Wert auf die Gesamtfolie, sodass in der pigmenthaltigen Teilschicht entsprechend der Dickenverteilung höhere TiO₂ Konzentrationen eingesetzt werden können.

Im Fall, das die reflektierende Zwischenschicht d) aus mindestens einer pigmentfreien und mindestens einer pigmenthaltigen Teilschicht besteht, können diese Teilschichten jeweils eine unterschiedliche oder gleiche Zusammensetzung bzw. polymere Materialien enthalten.

Bevorzugt weist die hinter den Zellen angeordnete reflektierende Klebefolie im Wesentlichen keine UVabsorbierenden Bestandteile auf, welche in die vor den Zellen angeordnete Klebefolie mit hoher Strahlungstransmission migrieren können.

Die reflektierende Klebefolie d) ist daher bevorzugt im Wesentlichen frei von UV-Absorbern d.h. deren Konzentration liegt unter 0,01 Gew.%, bevorzugt unter 0,001 Gew.%, besonders bevorzugt bei 0 Gew.%, jeweils bezogen auf die Folienmischung.

Zusätzlich zum weitgehenden Verzicht auf UV-Absorber können die erfindungsgemäß verwendeten Klebefolien d) mit einem oder mehreren nicht-aromatischen Lichtstabilisatoren, insbesondere mit sterisch gehinderten (nicht-aromatischen) Aminen vom Typ HALS und/oder sterisch gehinderten (nicht-aromatischen) Aminoethern (NOR-HALS) ausgerüstet werden. Erfindungsgemäß verwendete Folien d) enthalten bevorzugt 0,005 - 1 Gew.-%, besonders bevorzugt 0,01 - 0,5 Gew.-%, insbesondere 0,05 - 0,3 Gew.-% und am meisten bevorzugt 0,10 - 0,25 Gew.-% an nicht-aromatischen Lichtstabilisatoren, wie sterisch gehinderten Aminen vom HALS oder NOR-HALS Typ. Insbesondere entahlen die Folien d) im Wesentlichen keine aromatischen UV-Absorber und 0,005 bis 1 Gew.% sterisch gehinderte Amine (HALS) und/oder sterisch gehinderte Aminoether (NOR-HALS). Besonders geeignete Amine sind sterisch gehinderte Amine der allgemeinen Formeln I, II und oder III.

In einer besonderen Ausführungsform besitzen die Klebefolien d) und b) bis auf die reflektierenden Pigmente eine identische Zusammensetzung.

Als Material für die Klebefolien mit hoher Strahlungstransmission b) und die reflektierenden Klebe- und Teilschichten d) können weichmacherhaltige Polyvinylacetale oder weichmacherhaltige Polyvinylbutyrale eingesetzt werden.

Die weichmacherhaltiges Polyvinylacetal enthaltenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Es ist auch möglich, die Acetalisierung mit anderen oder weiteren Aldehyden mit 5-10 Kohlenstoffatomen (z.B. wie Valeraldehyd) durchzuführen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98% hydrolysiert und enthalten 1 bis 10 Gew. auf Ethylen basierende Einheiten (z.B. Typ "Exceval" der Kuraray Europe GmbH).

Polyvinylacetale enthalten neben den Acetaleinheiten noch aus Vinylacetat und Vinylalkohol resultierende Einheiten. Die erfindungsgemäß verwendeten weichmacherhaltige Polyvinylacetale weisen bevorzugt einen Polyvinylalkoholanteil von weniger als 22 Gew.%, weniger als 20 Gew.% oder insbesondere weniger als 18 Gew.% auf. Ein Polyvinylalkoholanteil von 12 Gew.% sollte nicht unterschritten werden.

Der Polyvinylacetatanteil des Polyvinylacetals liegt bevorzugt unter 5 Gew.%, bevorzugt unter 3 Gew.% und insbesondere unter 2 Gew.% Aus dem Polyvinylalkoholanteil und dem Restacetatgehalt kann der Acetalisierungsgrad rechnerisch ermittelt werden.

Die erfindungsgemäß eingesetzten Klebefolien mit hoher Strahlungstransmmission b) und die reflektierenden Folien d) weisen bei einer Umgebungsfeuchte von 85% rF bei 23°C bevorzugt einen spezifischen Widerstand von mindestens 1E+10 ohm*cm, bevorzugt mindestens 5E+10 ohm*cm, bevorzugt 1E+11 ohm*cm, bevorzugt 5E+11 ohm*cm, bevorzugt 1E+12, bevorzugt 5E+12 ohm*cm, bevorzugt 1E+13 ohm*cm auf.

Bevorzugt weisen die erfindungsgemäß eingesetzten Folien, auf Basis von weichmacherhaltigem Polyvinylacetal einen Weichmachergehalt von maximal 40 Gew.%, 35 Gew.%, 32 Gew.%, 30 Gew.%, 28 Gew.%, 26 Gew.%, 24 Gew.%, 22 Gew.%, 20 Gew.%, 18 Gew.%, 16 Gew.% auf, wobei ein Weichmachergehalt von 15 Gew.% aus Gründen der Verarbeitbarkeit der Folie nicht unterschritten werden sollte (jeweils bezogen auf die gesamte Folienformulierung). Folien b) und d) können einen oder mehrere Weichmacher enthalten.

Grundsätzlich geeignete Weichmacher sind eine oder mehrere Verbindungen ausgewählt aus den folgenden Gruppen:
- Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyladipaten, Diisononyladipat, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykol-bis-(2-ethylhexanoat), Triethylenglykol-bis-(2-ethylhexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat, Tetraethylenglykoldimethylether und/oder Dipropylenglykolbenzoat
- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Gut geeignet als Weichmacher für die erfindungsgemäß eingesetzten Folien b) und d) sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), 1,2-Cyclohexandicarbonsäurediisononylester (DINCH), Diisononyladipat (DINA) und Dipropylenglykolbenzoat.

Ganz besonders geeignet als Weichmacher für die erfindungsgemäß eingesetzten Folien b) und d) sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | Abkürzung | 100 x O/(C+H) |
|---|---|---|
| Di-2-ethylhexylsebacat | (DOS) | 5,3 |
| Diisononyladipat | (DINA) | 5,3 |
| 1,2-Cyclohexandicarbonsäurediisononylester | (DINCH) | 5,4 |
| Di-2-ethylhexyladipat | (DOA) | 6,3 |
| Di-2-ethylhexylphthalat | (DOP) | 6,5 |
| Dihexyladipat | (DHA) | 7,7 |
| Dibutylsebacat | (DBS) | 7,7 |
| Triethylenglykol-bis-2-propylhexanoat | | 8,6 |
| Triethylenglykol-bis-i-nonanoat | | 8,6 |
| Di-2-butoxyethylsebacat | (DBES) | 9,4 |
| Triethylenglykol-bis-2-ethylhexanoat | (3G8) | 9,4 |

Das Haftungsvermögen von Polyvinylacetalfolien an Glas wird üblicherweise durch die Zugabe von Haftungsregulatoren wie z. B. die in WO 03/033583 A1 offenbarten Alkali- und/oder Erdalkalisalze von organischen Säuren eingestellt. Als besonders geeignet haben sich Kaliumacetat und/oder Magnesiumacetat herausgestellt. Zudem enthalten Polyvinylacetale aus dem Herstellungsprozess häufig Alkali- und/oder Erdalkalisalze von anorganischen Säuren, wie z.B. Natriumchlorid.

Da Alkalimetallsalze ebenfalls einen Einfluss auf den spezifischen Widerstand haben, ist der Einsatz von weichmacherhaltigen, auf Polyvinylacetal basierenden Folien b) und d) mit weniger als 100 ppm, besonders bevorzugt mit weniger als 50 ppm und insbesondere mit weniger als 30 ppm Alkalimetallionen zweckmäßig. Dies kann durch entsprechende Waschverfahren des Polyvinylacetals und durch Verwendung von mehrwertigen Metallsalzen ausgewählt aus der Gruppe Erdalkalimetall-, Zink- und Aluminiumsalze als basischem Stabilisator erreicht werden. Bevorzugt werden Magnesiumsalze, insbesondere Magnesiumacetat, -propionat, -butyrat, -hexanoat, -octoat und Magnesiumstearat. Die erfindungsgemäß verwendete reflektierende Folie weist bevorzugt einen Alkalititer von größer 0, besonders bevorzugt größer 5, insbesondere größer 10 oder größer 15 auf. Ein Alkalititer von 100 sollte nicht überschritten werden, da anderenfalls Gelbfärbung der Folie resultieren kann.

Weiterhin kann die möglicherweise vom Wassergehalt der Folie abhängende Ionenbeweglichkeit und damit der spezifische Widerstand durch den Zusatz von pyrogener Kieselsäure beeinflusst werden. Bevorzugt enthalten die Folien d) zusätzlich zum TiO₂-Pigment 0.001 bis 15 Gew.%, bevorzugt 2 bis 5 Gew.% pyrogenes SiO₂.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

Die Gesamtdicke der Klebefolien b) und d) liegt üblicherweise bei 0.30, 0.38, 0,45, 0.51, 0.76, 1.14 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.
Zur Herstellung von kristallinen oder geträgerten Solarmodulen werden die photosensitiven Halbleiterschichten von Klebefolien b) und d)eingekapselt, d.h. dass die photosensitiven Halbleiterschichten c) mit mindestens einer Klebefolie b) mit der transparenten Frontabdeckung a) und die rückwärtigen Abdeckung e) durch mindestens eine reflektierende Klebefolie d) verklebt sind. Die Folien b) weisen bevorzugt bis auf die reflektierenden Pigmente eine gleiche Zusammensetzung wie reflektierende Klebefolien d) auf.

Zur Laminierung des so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbundverglasungen innerhalb von 10 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Erfindungsgemäße Photovoltaikmodule können als Fassadenbauteil, Dachflächen, Wintergartenabdeckung, Schallschutzwand, Balkon- oder Brüstungselement oder als Bestandteil von Fensterflächen verwendet werden.

### Beispiele:

Zu Testzwecken wurden kristallinen Solarzellen mit diesen Folien zwischen Optiwhite-Glasscheiben in einem anspruchsgemäßen Aufbau laminiert. Hierzu wurden als Klebefolien mit hoher Strahlungstransmission b) gemäß EP 2408619 A1 und reflektierende Klebefolien d) gemäß EP 2395561 A1 verwendet. Beide Folientypen bestanden aus weichmacherhaltigem Polyvinylbutyral (PVB) mit einem Polyvinylacetatgehalt von ca. 1 Gew.%.

Als Vergleich diente ein baugleiches Laminat, bei dem statt der Klebefolie mit hoher Stahlungstransmission b) handelsübliche PVB-Folien enthaltend UV-Stabilisatoren verwendet.

Es zeigt sich, dass die erfindungsgemäßen Photovoltaikmodule im Flasher eine um 3,2 % verbesserte Effizienz gegenüber den Vergleichsmodulen aufweisen.

## Patentansprüche

1. Photovoltaikmodul, umfassend ein Laminat aus
a) einer transparenten Frontabdeckung
b) mindestens einer Klebefolie mit hoher Strahlungstransmission, enthaltend weichmacherhaltiges Polyvinylacetal
c) einer oder mehreren photosensitiven Halbleiterschichten
d) mindestens einer reflektierenden Klebefolie, enthaltend weichmacherhaltiges Polyvinylacetal
e) einer rückwärtigen Abdeckung
**dadurch gekennzeichnet, dass** die Klebefolie mit hoher Strahlungstransmission b) eine UV-Transmission von mehr als 35 % aufweist, bestimmt zwischen zwei Scheiben Weißglas von 2 mm Dicke nach EN410.

2. Photovoltaikmodul nach Anspruch 1 **dadurch gekennzeichnet, dass** die Klebefolie mit hoher Strahlungstransmission b) ein Polyvinylacetal enthält, das durch Acetalisierung von Polyvinylalkohol hergestellt wird, der in einer 4 Gew.% wässrigen Lösung eine Extinktion bei 280 nm von weniger als 0,5 % aufweist.

3. Photovoltaikmodul nach Anspruch 1 oder 2 **dadurch gekennzeichnet, dass** die Klebefolie mit hoher Strahlungstransmission b) im Wesentlichen frei von UV-Absorber ist.

4. Photovoltaikmodul nach einem der Ansprüche 1 bis 3 **dadurch gekennzeichnet, dass** die Klebefolie mit hoher Strahlungstransmission b) 0,001 bis 5 Gew.% nicht-aromatische Lichtstabilisatoren enthält.

5. Photovoltaikmodule nach Anspruch 4 **dadurch gekennzeichnet, dass** als nicht-aromatischer Lichtstabilisator sterisch gehinderte Amine (HALS) oder sterisch gehinderte Aminoether (NOR-HALS) eingesetzt werden.

6. Photovoltaikmodul nach einem der Ansprüche 1 bis 5 **dadurch gekennzeichnet, dass** die Klebefolie mit hoher Strahlungstransmission b) im Wesentlichen keine aromatischen UV-Absorber und 0,005 bis 1 Gew.% sterisch gehinderte Amine (HALS) und/oder sterisch gehinderte Aminoether (NOR-HALS) als nicht-aromatische Lichtschutzmittel enthält.

7. Photovoltaikmodul nach einem der Ansprüche 1 bis 7 **dadurch gekennzeichnet, dass** die reflektierende Klebefolie d) Titandioxidpigment enthält.

8. Photovoltikmodul nach Anspruch 7 **dadurch gekennzeichnet, dass** die Titandioxidpigmente einen TiO₂-Gehalt von 50 bis 94 Gew.% aufweisen.

9. Photovoltaikmodul nach einem der Ansprüche 7 bis 8 **dadurch gekennzeichnet, dass** das Titandioxidpigment mit einer oder mehrerer Verbindungen der Gruppe Zinkoxid, Siliziumoxid, Aluminiumoxid und/oder Zirkoniumoxid beschichtet ist.

10. Photovoltaikmodul nach einem der Ansprüche 7 bis 9 **dadurch gekennzeichnet, dass** die reflektierende Klebefolie d) im wesentlichen frei von UV-Absorber ist.

11. Photovoltaikmodul nach einem der Ansprüche 1 bis 10 **dadurch gekennzeichnet, dass** die reflektierende Klebefolie d) aus mindestens einer pigmentfreien und mindestens einer pigmenthaltigen Teilschicht besteht.

12. Photovoltaikmodul nach einem der Ansprüche 1 bis 11 **dadurch gekennzeichnet, dass** die reflektierende Klebefolie d) aus mindestens einer pigmentfreien und mindestens einer pigmenthaltigen Teilschicht besteht und diese Teilschichten das gleiche polymere Material enthalten.

13. Photovoltaikmodul nach einem der Ansprüche 1 bis 12 **dadurch gekennzeichnet, dass** die reflektierende Klebefolie d) und die Klebefolie mit hoher Strahlungstransmission b) jeweils gleich oder verschieden mindestens einen Weichmacher ausgewählt aus der Gruppe Di-2-ethylhexylsebacat (DOS), 1,2-Cyclohexandicarbonsäurediisononylester (DINCH), Di-2-ethylhexyladipat (DOA), Di-2-ethylhexylphthalat (DOP), Dihexyladipat (DHA), Dibutylsebacat (DBS), Triethylenglykol-bis-2-propylhexanoat, Triethylenglykol-bis-i-nonaoat, Di-2-butoxyethylsebacat (DBES) und Triethylenglykol-bis-2-ethylhexanoat (3G8) aufweisen.
